# FASCICULE DE BREVET EUROPEEN

(11) **EP 3 206 303 B1**
(45) Date de publication et mention de la délivrance du brevet: **07.03.2018**
(21) Numéro de dépôt: 16183459.3
(22) Date de dépôt: 09.08.2016
(51) Int. Cl.: H03L 7/107, H01G 7/06, H03B 5/12, H03H 7/38

(54) **DISPOSITIF DE COMMANDE D'UN CONDENSATEUR DE CAPACITÉ RÉGLABLE**
STEUERVORRICHTUNG EINES KONDENSATORS MIT REGULIERBARER KAPAZITÄT
DEVICE FOR CONTROLLING A CAPACITOR WITH ADJUSTABLE CAPACITANCE

(30) Priorité: 10.02.2016 FR 1651064
(43) Date de publication de la demande: 16.08.2017
(73) Titulaire: STMicroelectronics (Tours) SAS, 37100 Tours (FR)
(72) Inventeur: Charley, Sylvain, 37390 Mettray (FR); Heurtier, Jérôme, 37000 Tours (FR); Jeuffrault, Laurent, 37100 Tours (FR)
(74) Mandataire: Thibon, Laurent

(56) Documents cités:
- US-A1- 2004 189 417
- US-A1- 2012 326 797
- Ken Kavanagh: "Boost Supply and High-Voltage DAC Provide Tuning Signal for Antennas and Filters", , 1 décembre 2010 (2010-12-01), page 1, XP055137122, Extrait de l'Internet: URL:http://www.analog.com/library/analogdi alogue/archives/44-12/tunable.pdf [extrait le 2014-08-28]

## Description

### Domaine

La présente demande concerne de façon générale les circuits électroniques et, plus particulièrement, la commande d'un condensateur dont la valeur est réglable par application d'une tension de polarisation. La présente description s'applique plus particulièrement à la commande de condensateurs de type BST (Baryum-Strontium-Titane).

### Exposé de l'art antérieur

Les condensateurs BST ont été développés essentiellement pour des applications radiofréquences, en particulier pour la téléphonie mobile. Disposer d'un condensateur dont la capacité est ajustable de façon analogique améliore de façon significative les performances en permettant d'adapter le dispositif comportant un tel condensateur à l'environnement extérieur.

Un condensateur BST se présente classiquement sous la forme d'un circuit intégré comportant au moins trois bornes, deux bornes correspondant aux électrodes du condensateur, destinées à être connectées à l'application radiofréquence, et une borne d'application d'un potentiel continu de polarisation. La capacité du condensateur se règle par la valeur du potentiel continu de polarisation qui lui est appliqué, généralement dans une plage allant de quelques volts à quelques dizaines de volts, typiquement entre 2 et 20 volts.

La tension de polarisation d'un condensateur BST est généralement fournie par un circuit de commande dédié, réalisant une conversion numérique-analogique haute tension, c'est-à-dire convertissant un mot numérique de configuration (généralement un octet) en une tension analogique continue à appliquer au condensateur pour fixer sa capacité.

La commande ou configuration d'un condensateur BST souffre aujourd'hui d'imprécision en raison, entre autres, de tolérances de fabrication, de variations liées à la température et de variations liées à l'hystérésis du condensateur.

Le document intitulé "Boost Supply and High-Voltage DAC Provide Tuning Signal for Antennas and Filters" de Ken Kavanagh (Analog Dialogue 44-12 Back Burner, December 2010) décrit un exemple de dispositive comportant un condensateur dont la valeur est réglable par application d'une tension de polarisation.

### Résumé

Ainsi, un mode de réalisation prévoit un dispositif comprenant : un premier condensateur de capacité réglable à une valeur de consigne par application d'une tension de polarisation ; un deuxième condensateur de capacité réglable à une valeur de consigne par application d'une tension de polarisation, le deuxième condensateur étant agencé pour recevoir la même tension de polarisation que le premier condensateur ; et un circuit de contrôle adapté à recevoir ladite valeur de consigne et à générer ladite tension de polarisation en tenant compte d'une grandeur représentative de la capacité du deuxième condensateur.

Selon un mode de réalisation, les premier et deuxième condensateurs sont appairés, de façon à présenter sensiblement la même variation en température.

Selon un mode de réalisation, les premier et deuxième condensateurs sont identiques aux dispersions de fabrication près.

Selon un mode de réalisation, le circuit de contrôle comprend un premier circuit formant avec le deuxième condensateur un oscillateur adapté à générer une première fréquence variant en fonction de la capacité du deuxième condensateur, et une boucle de rétroaction adaptée à ajuster la tension de polarisation pour asservir la première fréquence sur une deuxième fréquence de référence.

Selon un mode de réalisation, le premier circuit comprend une résistance réglable, la valeur de la première fréquence dépendant en outre de la valeur de la résistance réglable.

Selon un mode de réalisation, la valeur de la résistance réglable est fixée en fonction de la valeur de consigne.

Selon un mode de réalisation, le circuit de contrôle comprend un deuxième circuit formant, avec un troisième condensateur fixe du dispositif, un oscillateur adapté à générer la deuxième fréquence de référence.

Selon un mode de réalisation, le troisième condensateur fixe est un condensateur métal-céramique-métal.

Selon un mode de réalisation, le deuxième circuit comprend une résistance non réglable, la valeur de la deuxième fréquence dépendant en outre de la valeur de la résistance non réglable.

Selon un mode de réalisation, la résistance réglable et la résistance non réglable sont appairées de façon à présenter sensiblement la même variation en température.

Selon un mode de réalisation, les premier et deuxième condensateurs sont intégrés dans une première puce comportant : des première et deuxième bornes reliées aux électrodes du premier condensateur ; une troisième borne d'application de la tension de polarisation ; et une quatrième borne reliée à une électrode du deuxième condensateur.

Selon un mode de réalisation, le circuit de contrôle est intégré dans une deuxième puce distincte de la première puce.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est un schéma électrique d'un exemple d'un mode de réalisation d'un dispositif comportant un condensateur de capacité réglable par application d'une tension de polarisation et un circuit de commande de ce condensateur ; et
la figure 2 est un schéma électrique illustrant plus en détail un exemple de réalisation du dispositif de la figure 1.

### Description détaillée

De mêmes éléments ont été désignés par de mêmes références aux différentes figures. Par souci de clarté, seuls les éléments utiles à la compréhension des modes de réalisation qui vont être décrits ont été représentés et seront détaillés. En particulier, la réalisation d'un condensateur BST n'a pas été détaillée, les modes de réalisation décrits étant compatibles avec les réalisations usuelles de condensateurs réglables par application d'une tension de polarisation (par exemple des condensateurs BST). De plus, les différentes applications possibles d'un condensateur BST n'ont pas non plus été détaillées, les modes de réalisation décrits étant, là encore, compatibles avec les applications usuelles. Dans la description qui suit, les expressions "approximativement", "environ" et "de l'ordre de" signifient à 10 % près, de préférence à 5 % près. Dans la présente description, on utilise le terme "connecté" pour désigner une liaison électrique directe, sans composant électronique intermédiaire, par exemple au moyen d'une ou plusieurs pistes conductrices, et le terme "couplé" ou le terme "relié", pour désigner une liaison électrique qui peut être directe (signifiant alors "connecté") ou indirecte (c'est-à-dire via un ou plusieurs composants intermédiaires).

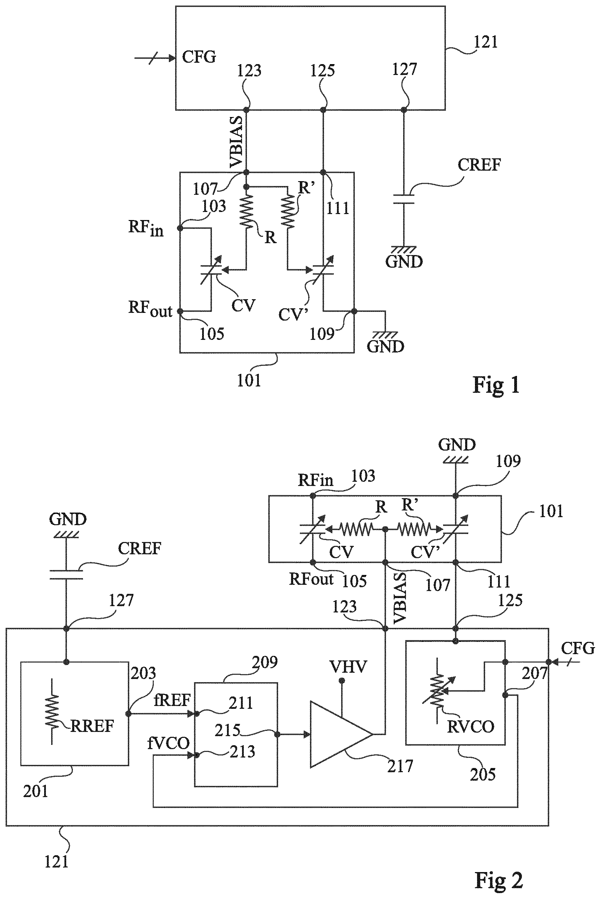

La figure 1 est un schéma électrique d'un exemple d'un mode de réalisation d'un dispositif comportant un condensateur de capacité réglable par application d'une tension de polarisation et un circuit de commande de ce condensateur.

Le dispositif de la figure 1 comprend un circuit intégré 101 comprenant un condensateur CV de capacité réglable par application d'une tension de polarisation, par exemple un condensateur BST. Le circuit intégré 101 comporte deux bornes 103 et 105 correspondant aux électrodes du condensateur CV, destinées à être connectées à l'application radiofréquence (RFᵢₙ, RFₒᵤₜ). Le circuit intégré 101 comporte en outre une borne 107 définissant une borne d'application d'un potentiel de polarisation VBIAS fixant la valeur de la capacité du condensateur CV. D'un point de vue électrique, ce potentiel de polarisation est appliqué par l'intermédiaire d'une résistance R.

Le dispositif de la figure 1 comprend en outre un deuxième condensateur CV' de capacité réglable par application d'une tension de polarisation, intégré dans le même circuit 101 que le condensateur CV. Les condensateurs CV et CV' sont appairés (matched en anglais), de façon à présenter sensiblement la même variation en température (en pourcent par degré). Le condensateur CV' est par exemple identique au condensateur CV aux dispersions de fabrication près. Le circuit intégré 101 comprend deux bornes 109 et 111 correspondant aux électrodes du condensateur CV'. La borne 109 est destinée à être reliée à un noeud GND d'application d'un potentiel de référence de l'application, par exemple la masse. La borne 111 est destinée à être reliée à un circuit de contrôle 121 qui va être décrit ci-après. Le condensateur CV' est agencé pour recevoir le même potentiel de polarisation VBIAS que le condensateur CV. Dans l'exemple représenté, le potentiel de polarisation VBIAS est appliqué sur le condensateur CV' par l'intermédiaire d'une résistance R'. La résistance R' est choisie sensiblement de même valeur que la résistance R.

Les condensateurs CV et CV' étant disposés dans la même puce 101, leurs différences de caractéristiques liées aux dispersions de fabrication et/ou aux variations de température sont très faibles. De plus, les condensateurs CV et CV' recevant à tout instant le même potentiel de polarisation VBIAS, leurs différences de caractéristiques liées à l'hystérésis (phénomène par lequel la conversion de la tension de consigne appliquée à un condensateur de capacité réglable par une tension de polarisation en une valeur de capacité dépend de l'historique d'utilisation du condensateur) sont aussi très faibles. Il en résulte que quelles que soient les conditions d'utilisation du circuit 101, le condensateur CV' ou condensateur témoin présente à tout instant une capacité appairée à celle du condensateur CV, par exemple sensiblement égale à celle du condensateur CV.

Le dispositif de la figure 1 comprend de plus un circuit de contrôle 121 adapté à recevoir une valeur de consigne sur une entrée CFG, par exemple une entrée numérique, et à générer le potentiel de polarisation VBIAS à appliquer sur la borne 107 du circuit 101 pour régler la capacité du condensateur CV à la valeur de consigne. Le circuit 121 est par exemple un circuit intégré distinct du circuit 101. Le circuit 121 comprend une borne 123 de fourniture du potentiel de polarisation VBIAS, reliée à la borne 107 du circuit 101. Le circuit 121 comprend de plus une borne 125 reliée à la borne 111 du circuit 101, c'est-à-dire à une électrode du condensateur témoin CV' du circuit 101. Le circuit 121 comprend en outre une borne 127 reliée à une électrode d'un condensateur de référence CREF du dispositif, externe au circuit 121. Dans cet exemple, l'électrode du condensateur CREF opposée à la borne 127 est reliée à la masse (noeud GND). Le circuit 121 peut comporter d'autres bornes non représentées, notamment des bornes d'alimentation. En pratique, le circuit 121 peut recevoir deux tensions d'alimentation distinctes, une première tension VDD, par exemple comprise entre 2 et 6 volts, adaptée à l'alimentation de circuits de conversion de la valeur de consigne appliquée sur l'entrée CFG du circuit 121 en une tension analogique image réduite de la tension VBIAS à appliquer sur la borne 107 du circuit 101, et une deuxième tension VHV supérieure à la tension VDD, par exemple comprise entre 10 et 30 V, adaptée à l'alimentation d'un étage d'amplification de sortie du circuit 121, fournissant le potentiel de polarisation VBIAS à appliquer sur la borne 107 du circuit 101.

Le circuit 121 est adapté à générer le potentiel de polarisation VBIAS à appliquer sur la borne 107 du circuit 101 en tenant compte non seulement de la valeur de consigne appliquée sur l'entrée CFG, mais aussi d'une grandeur représentative de la capacité du condensateur CV', relié au circuit 121 par les bornes 111 du circuit 101 et 125 du circuit 121. Ainsi, le potentiel de polarisation VBIAS est généré en tenant compte de la capacité effective du condensateur CV', qui est elle-même sensiblement identique à la capacité du condensateur CV. Ceci permet une commande précise du condensateur CV. En outre, l'obtention d'une grandeur représentative de la capacité du condensateur CV via la borne 111 du circuit 101 est non invasive pour l'application radiofréquence, la borne 111 du circuit 101 n'étant pas connectée à l'application radiofréquence.

Plus particulièrement, dans l'exemple représenté, le circuit de contrôle 121 est adapté à comparer une première grandeur fonction de la capacité du condensateur CV' et de la valeur de consigne appliquée sur l'entrée CFG à une deuxième grandeur fonction de la capacité du condensateur CREF, et à rétroagir en boucle fermée sur la valeur du potentiel VBIAS de façon à minimiser l'écart entre ces deux grandeurs.

Le condensateur CREF est non réglable et est choisi pour avoir une capacité stable en température, par exemple une capacité présentant une variation en température inférieure à +/-0,4 % dans la plage de températures allant de -25 à +85°C. Le condensateur CREF est par exemple un condensateur de type métal-céramique-métal.

La figure 2 est un schéma électrique illustrant plus en détail un exemple de réalisation du dispositif de la figure 1. Plus particulièrement, la figure 2 est un schéma électrique reprenant les éléments du schéma de la figure 1, mais dans lequel un exemple de réalisation du circuit de contrôle 121 a été détaillé.

Dans l'exemple de la figure 2, le circuit 121 comprend un premier circuit 201 relié à la borne 127 de connexion au condensateur CREF, et formant avec le condensateur CREF un oscillateur adapté à générer, sur un noeud de sortie 203 du circuit 201, un signal oscillant dont la fréquence est fixée par le produit RREF*CREF, où RREF est une résistance interne au circuit 201.

Le circuit 121 comprend en outre un deuxième circuit 205 relié à la borne 125 de connexion au condensateur CV', formant avec le condensateur CV' un oscillateur adapté à générer, sur un noeud de sortie 207 du circuit 205, un signal oscillant dont la fréquence est fixée par le produit RVCO*CV', où RVCO est une résistance interne au circuit 205.

Dans l'exemple représenté, la résistance RREF du circuit oscillant 201 est une résistance fixe (non réglable), et la résistance RVCO du circuit oscillant 205 est une résistance réglable. A cette différence près, le circuit 201 est par exemple identique au circuit 205. Les circuits oscillants 201 (ensemble avec le condensateur CREF) et 205 (ensemble avec le condensateur CV') sont par exemple des oscillateurs RC à déphasage. Les résistances RREF et RVCO sont appairées, de façon à présenter sensiblement la même variation en température.

Le circuit 121 comprend en outre un circuit 209 de comparaison de fréquence, comportant deux noeuds d'entrée 211 et 213 reliés respectivement aux noeuds de sortie 203 et 207 des circuits oscillants 201 et 205, et un noeud de sortie 215. Le circuit 209 est adapté à fournir sur son noeud de sortie 215 un potentiel continu de niveau proportionnel à la différence de fréquence entre les deux signaux d'entrée appliqués sur ses noeuds 211 et 213.

Le circuit 121 comprend de plus un amplificateur 217 dont l'entrée est reliée à la sortie 215 du circuit de comparaison de fréquence 209, éventuellement par l'intermédiaire d'un circuit (non représenté) de mise en forme du signal de sortie du circuit 209. La sortie de l'amplificateur 217 est reliée à la borne 123 de fourniture du potentiel de polarisation VBIAS.

Le fonctionnement du dispositif de la figure 2 est le suivant. La résistance RVCO est réglée à une valeur prédéterminée en fonction du signal de consigne appliqué sur l'entrée CFG du circuit 121. A titre d'exemple, la valeur de consigne appliquée sur l'entrée CFG du circuit 121 est une valeur numérique, et le circuit 121 comprend une table de correspondance comportant, pour chaque valeur possible du signal numérique de consigne, un réglage spécifique de la résistance RVCO. La résistance RVCO est par exemple une résistance réglable numériquement. La résistance RVCO comporte par exemple une pluralité de résistances élémentaires connectées en série, chaque résistance élémentaire pouvant être court-circuitée par un interrupteur.

La fréquence fVCO du signal de sortie de l'oscillateur formé par le circuit 205 et le condensateur CV' est fixée par le produit de la résistance RVCO par la capacité effective du condensateur CV'. La boucle de rétroaction comprenant le comparateur de fréquence 209 et l'amplificateur 217 agit sur le potentiel VBIAS de commande des condensateurs CV et CV' de manière à verrouiller la fréquence fVCO sur la fréquence de référence fREF fournie par l'oscillateur formé par le circuit 201 et le condensateur CREF. Ainsi, pour chaque valeur du signal de consigne appliqué sur l'entrée CFG du circuit 121, la boucle de rétroaction du circuit 121 fixe la capacité du condensateur CV' (et donc celle du condensateur CV) à une valeur telle que la fréquence de sortie de l'oscillateur formé par le circuit 205 et le condensateur CV' soit sensiblement égale à la fréquence de sortie de l'oscillateur formé par le circuit 201 et le condensateur CREF.

Un avantage des modes de réalisation décrits est qu'ils permettent de réaliser une commande précise de la capacité du condensateur CV. En particulier, les modes de réalisation décrits permettent de diminuer significativement les imprécisions de commande liées à l'hystérésis du matériau diélectrique du condensateur. Il est désormais envisageable d'atteindre des précisions de l'ordre du pourcent. Cette précision est notamment compatible avec la réalisation de filtres radiofréquences réglables en fréquence par l'intermédiaire d'un ou plusieurs condensateurs de capacité réglable, pouvant être utilisés dans des terminaux de téléphonie mobile multistandard, pour former des circuits d'accord d'antenne multi-bandes, d'encombrement beaucoup plus réduit que les circuits connus à base de filtres commutés.

Des modes de réalisation particuliers ont été décrits. Diverses variantes et modifications apparaîtront à l'homme de l'art. En particulier, les modes de réalisation décrits ne se limitent pas à l'exemple particulier de réalisation du circuit de contrôle 121 décrit en relation avec la figure 2. En particulier, on a décrit ci-dessus un exemple de réalisation du circuit de contrôle 121 dans lequel on compare une fréquence fVCO variant en fonction de la capacité du condensateur CV' et de la valeur de consigne appliquée sur l'entrée CFG, à une fréquence de référence fREF fixée par la valeur de la capacité du condensateur CREF. Les deux grandeurs utilisées pour comparer la valeur effective de la capacité du condensateur CV' à la valeur de la capacité du condensateur CREF et verrouiller la valeur effective de la capacité du condensateur CV' sur la valeur de la capacité du condensateur CREF peuvent toutefois être des grandeurs autres que des fréquences. Plus particulièrement, toutes autres grandeurs représentatives des produits RREF*CREF et RVCO*CV' respectivement, peuvent être utilisées.

De plus, les modes de réalisation décrits ne se limitent pas à l'exemple décrit ci-dessus dans lequel un condensateur de référence CREF est utilisé pour générer la fréquence de référence fREF. A titre de variante, la fréquence fREF peut être générée à partir d'un signal disponible dans le dispositif pour d'autres fonctions, par exemple un signal généré par un oscillateur à quartz.

## Revendications

1. Dispositif comprenant :
un premier condensateur (CV) de capacité réglable à une valeur de consigne par application d'une tension de polarisation (VBIAS) ; et
un deuxième condensateur (CV') de capacité réglable à une valeur de consigne par application d'une tension de polarisation, le deuxième condensateur (CV') étant agencé pour recevoir la même tension de polarisation (VBIAS) que le premier condensateur (CV),
**caractérisé en ce qu'**il comprend en outre un circuit de contrôle (121) adapté à recevoir ladite valeur de consigne et à générer ladite tension de polarisation (VBIAS) en tenant compte d'une grandeur représentative de la capacité du deuxième condensateur (CV'), et **en ce que** les premier (CV) et deuxième (CV') condensateurs sont appairés, de façon à présenter sensiblement la même variation en température.

2. Dispositif selon la revendication 1, dans lequel les premier (CV) et deuxième (CV') condensateurs sont identiques aux dispersions de fabrication près.

3. Dispositif selon la revendication 1 ou 2, dans lequel le circuit de contrôle (121) comprend un premier circuit (205) formant avec le deuxième condensateur (CV') un oscillateur adapté à générer une première fréquence (fVCO) variant en fonction de la capacité du deuxième condensateur (CV'), et une boucle de rétroaction (209, 217) adaptée à ajuster ladite tension de polarisation (VBIAS) pour asservir ladite première fréquence (fVCO) sur une deuxième fréquence (fREF) de référence.

4. Dispositif selon la revendication 3, dans lequel le premier circuit (205) comprend une résistance (RVCO) réglable, la valeur de la première fréquence (fVCO) dépendant en outre de la valeur de ladite résistance réglable (RVCO).

5. Dispositif selon la revendication 4, dans lequel la valeur de ladite résistance réglable (RVCO) est fixée en fonction de ladite valeur de consigne.

6. Dispositif selon l'une quelconque des revendications 2 à 5, dans lequel le circuit de contrôle (121) comprend un deuxième circuit (201) formant, avec un troisième condensateur fixe (CREF) du dispositif, un oscillateur adapté à générer ladite deuxième fréquence (fREF) de référence.

7. Dispositif selon la revendication 6, dans lequel le troisième condensateur fixe (CREF) est un condensateur métal-céramique-métal.

8. Dispositif selon la revendication 6 ou 7, dans lequel le deuxième circuit (201) comprend une résistance (RREF) non réglable, la valeur de la deuxième fréquence (fREF) dépendant en outre de la valeur de ladite résistance non réglable (RREF).

9. Dispositif selon la revendication 8 dans son rattachement à la revendication 4, dans lequel ladite résistance réglable (RVCO) et ladite résistance non réglable (RREF) sont appairées de façon à présenter sensiblement la même variation en température.

10. Dispositif selon l'une quelconque des revendications 1 à 9, dans lequel les premier (CV) et deuxième (CV') condensateurs sont intégrés dans une première puce (101) comportant :
des première (103) et deuxième (105) bornes reliées aux électrodes du premier condensateur (CV) ;
une troisième borne (107) d'application de ladite tension de polarisation (VBIAS) ; et
une quatrième borne (111) reliée à une électrode du deuxième condensateur (CV').

11. Dispositif selon la revendication 10, dans lequel le circuit de contrôle (121) est intégré dans une deuxième puce distincte de la première puce (101).

## Patentansprüche

1. Eine Vorrichtung, die Folgendes aufweist:
einen ersten Kondensator (CV) mit einer Kapazität, die auf einen Setzpunktwert einstellbar ist durch Anlegen einer Biasspannung (VBIAS); und
einen zweiten Kondensator (CV') mit einer Kapazität, die auf einen Setzpunkwert einstellbar ist durch Anlegen einer Biasspannung, wobei der zweite Kondensator (CV') angeordnet ist, dieselbe Biasspannung (VBIAS) wie der erste Kondensator (CV) zu empfangen,
**dadurch gekennzeichnet, dass** die Vorrichtung ferner eine Steuerschaltung (121) aufweist, die in der Lage ist, den Setzpunktwert zu empfangen und die Biasspannung (VBIAS) zu erzeugen während sie eine Größe in Betracht zieht, welche die Kapazität des zweiten Kondensators (CV') repräsentiert, und dass der erste (CV) und zweite (CV') Kondensator angepasst sind, so dass sie im Wesentlichen dieselbe Temperaturvariation besitzen.

2. Vorrichtung nach Anspruch 1, wobei der erste (CV) und zweite (CV') Kondensator innerhalb der Herstellungsabweichungen beziehungsweise Toleranzen identisch sind.

3. Vorrichtung nach Anspruch 1 oder 2, wobei die Steuerschaltung (121) eine erste Schaltung (205) aufweist, die mit dem zweiten Kondensator (CV') einen Oszillator bildet, der geeignet ist, eine erste Frequenz (fVCO) zu erzeugen, die sich gemäß der Kapazität des zweiten Kondensators (CV') verändert, und wobei die Steuerschaltung (121) eine Rückkopplungsschleife (209, 217) aufweist, die in der Lage ist, die Biasspannung (VBIAS) einzustellen, um die erste Frequenz (fVCO) mit einer zweiten Referenzfrequenz (fREF) zu steuern.

4. Vorrichtung nach Anspruch 3, wobei die erste Schaltung (205) einen einstellaren Widerstand (RVCO) aufweist, wobei der Wert der ersten Frequenz (fVCO) ferner von dem Wert des einstellbaren Widerstandes (RVCO) abhängt.

5. Vorrichtung nach Anspruch 4, wobei der Wert des einstellbaren Widerstandes (RVCO) gemäß dem Setzpunktwert eingestellt ist.

6. Vorrichtung nach einem der Ansprüche 2 bis 5, wobei die Steuerschaltung (121) eine zweite Schaltung (201) aufweist, die mit einem dritten festen Kondensator (CREF) der Vorrichtung einen Oszillator bildet, der geeignet ist, die zweite Referenzfrequenz (fREF) zu erzeugen.

7. Vorrichtung nach Anspruch 6, wobei der dritte feste Kondensator (CREF) ein Metall-Keramik-Metall Kondensator ist.

8. Vorrichtung nach Anspruch 6 oder 7, wobei die zweite Schaltung (201) einen nicht-einstellbaren Widerstand (RREF) aufweist, wobei der Wert der zweiten Frequenz (fREF) ferner von dem Wert des nicht-einstellbaren Widerstandes (RREF) abhängt.

9. Vorrichtung nach Anspruch 8 und Anspruch 4, wobei der einstellbare Widerstand (RVCO) und der nicht-einstellbare Widerstand (RREF) aneinander angepasst sind, sodass sie im Wesentlichen dieselbe Temperaturvariation aufweisen.

10. Vorrichtung nach einem der Ansprüche 1 bis 9, wobei der erste (CV) und der zweite (CV') Kondensator in einem ersten Chip (101) integriert sind, der Folgendes aufweist:
erste (103) und zweite (105) Anschlüsse, die mit den Elektroden des ersten Kondensators (CV) gekoppelt sind;
einen dritten Anschluss (107) zum Anlegen der Biasspannung (VBIAS); und
einen vierten Anschluss (111), der an eine Elektrode des zweiten Kondensators (CV') gekoppelt ist.

11. Vorrichtung nach Anspruch 10, wobei die Steuerschaltung (121) in einem zweiten Chip integriert ist, der sich von dem ersten Chip (101) unterscheidet.

## Claims

1. A device comprising:
a first capacitor (CV) having a capacitance adjustable to a set point value by application of a bias voltage (VBIAS); and
a second capacitor (CV') having a capacitance adjustable to a set point value by application of a bias voltage, the second capacitor (CV') being arranged to receive the same bias voltage (VBIAS) as the first capacitor (CV),
**characterized in that** it further comprises a control circuit (121) capable of receiving said set point value and of generating said bias voltage (VBIAS) while taking into account a quantity representative of the capacitance of the second capacitor (CV'), and **in that** the first (CV) and second (CV') capacitors are matched, to substantially have the same temperature variation.

2. The device of claim 1, wherein the first (CV) and second (CV') capacitors are identical to within manufacturing dispersions.

3. The device of claim 1 or 2, wherein the control circuit (121) comprises a first circuit (205) forming with the second capacitor (CV') an oscillator capable of generating a first frequency (fVCO) varying according to the capacitance of the second capacitor (CV'), and a feedback loop (209, 217) capable of adjusting said bias voltage (VBIAS) to control said first frequency (fVCO) with a second reference frequency (fREF).

4. The device of claim 3, wherein the first circuit (205) comprises an adjustable resistor (RVCO), the value of the first frequency (fVCO) further depending on the value of said adjustable resistor (RVCO).

5. The device of claim 4, wherein the value of said adjustable resistor (RVCO) is set according to said set point value.

6. The device of any of claims 2 to 5, wherein the control circuit (121) comprises a second circuit (201) forming, with a third fixed capacitor (CREF) of the device, an oscillator capable of generating said second reference frequency (fREF).

7. The device of claim 6, wherein the third fixed capacitor (CREF) is a metal-ceramic-metal capacitor.

8. The device of claim 6 or 7, wherein the second circuit (201) comprises a non-adjustable resistor (RREF), the value of the second frequency (fREF) further depending on the value of said non-adjustable resistor (RREF).

9. The device of claim 8 and of claim 4, wherein said adjustable resistor (RVCO) and said non-adjustable resistor (RREF) are matched to have substantially the same temperature variation.

10. The device of any of claims 1 to 9, wherein the first (CV) and second (CV') capacitors are integrated in a first chip (101) comprising:
first (103) and second (105) terminals coupled to the electrodes of the first capacitor (CV);
a third terminal (107) of application of said bias voltage (VBIAS); and
a fourth terminal (111) coupled to an electrode of the second capacitor (CV').

11. The device of claim 10, wherein the control circuit (121) is integrated in a second chip different from the first chip (101).
